(19) Europäisches Patentamt
European Patent Office
Office européen des brevets

(11) **EP 4 328 361 A1**

(12) **EUROPEAN PATENT APPLICATION**
published in accordance with Art. 153(4) EPC

(43) Date of publication:
**28.02.2024 Bulletin 2024/09**

(21) Application number: **22791745.7**

(22) Date of filing: **19.04.2022**

(51) International Patent Classification (IPC):
*C30B 29/62* (2006.01)    *B24B 7/22* (2006.01)
*C22C 38/00* (2006.01)    *C30B 29/52* (2006.01)
*H01L 41/20* (2006.01)    *H01L 41/47* (2013.01)

(52) Cooperative Patent Classification (CPC):
**B24B 7/22; C22C 38/00; C30B 29/52; C30B 29/62; H10N 35/01; H10N 35/85**

(86) International application number:
**PCT/JP2022/018229**

(87) International publication number:
**WO 2022/224974 (27.10.2022 Gazette 2022/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.04.2021 JP 2021073603**

(71) Applicant: SUMITOMO METAL MINING CO., LTD.
Tokyo
105-8716 (JP)

(72) Inventors:
• OKUBO, Kazuhiko
  Ome-shi, Tokyo 198-8601 (JP)
• SENDAN, Yuki
  Ome-shi, Tokyo 198-8601 (JP)
• IZUMI, Kiyoshi
  Ome-shi, Tokyo 198-8601 (JP)

(74) Representative: Müller-Boré & Partner
Patentanwälte PartG mbB
Friedenheimer Brücke 21
80639 München (DE)

(54) **MAGNETOSTRICTIVE MEMBER AND METHOD FOR PRODUCING MAGNETOSTRICTIVE MEMBER**

(57)    Provided are a magnetostrictive member having a high magnetostriction constant and a high parallel magnetostriction amount and small variations in the magnetostriction constant and the parallel magnetostriction amount among members and a method for manufacturing such a magnetostrictive member. The magnetostrictive member contains an iron-based alloy crystal having magnetostrictive characteristics and is a plate-like body having front and back faces. In one of the front and back faces, a thickness and a surface roughness Ra of the magnetostrictive member satisfy Expression (1) below:

Expression (1)

$$\log \mathrm{Ra} \geq 0.48t - 0.62$$

In Expression (1) above, log indicates a common logarithm, Ra the surface roughness ($\mu$m), and t the thickness of the magnetostrictive member (mm).

Fig. 1

GRINDING DIRECTION, LONG-SIDE DIRECTION
GROOVE 2    FRONT FACE 3 (100 PLANE)
SIDE FACE 5 (100 PLANE)
THICKNESS DIRECTION
BACK FACE 4 (100 PLANE)
SIDE FACE 6 (100 PLANE)

EP 4 328 361 A1

**Description**

Technical Field

The present invention relates to a magnetostrictive member and a method for manufacturing a magnetostrictive member.

Background Art

Magnetostrictive materials are attracting attention as functional materials. For example, Fe-Ga alloys, which are iron-based alloys, are materials exhibiting the magnetostrictive effect and the reverse magnetostrictive effect, showing a large magnetostriction of about 100 to 350 ppm. For this reason, in recent years, they have attracted attention as a material for vibration power generation in the energy harvesting field and are expected to be applied to wearable terminals and sensors. As a method for manufacturing a single crystal of an Fe-Ga alloy, a method for growing a single crystal by the pull-up method (the Czochralski method, hereinafter abbreviated as the "Cz method") is known (e.g., Patent Literature 1). In addition, as methods of manufacture other than the Cz method, the vertical Bridgman method (the VB method) and the vertical temperature gradient freeze method (the VGF method) are known (e.g., Patent Literature 2 and Patent Literature 3).

The Fe-Ga alloy has an easy axis of magnetization in the <100> orientation of the crystal and can exhibit large magnetic distortion in this orientation. Conventionally, magnetostrictive members of the Fe-Ga alloy have been manufactured by cutting a single crystal part oriented in the <100> orientation from a polycrystal of the Fe-Ga alloy to a desired size (e.g., Non-Patent Literature 1); crystal orientation significantly affects magnetostrictive characteristics, and thus a single crystal in which the direction in which the magnetostriction of magnetostrictive members is required and the <100> orientation, in which the magnetic strain of the crystal is maximum, are matched with each other is considered to be optimum for the material of magnetostrictive members.

The single crystal of the Fe-Ga alloy exhibits positive magnetostriction when a magnetic field is applied in parallel to the <100> orientation of the single crystal (hereinafter referred to as a "parallel magnetostriction amount"). On the other hand, when a magnetic field is applied perpendicularly to the <100> orientation, negative magnetostriction is exhibited (hereinafter referred to as a "perpendicular magnetostriction amount"). As the intensity of the applied magnetic field is gradually increased, the parallel magnetostriction amount or the perpendicular magnetostriction amount is saturated. A magnetostriction constant ($3/2\lambda_{100}$) is determined by the difference between the saturated parallel magnetostriction amount and the saturated perpendicular magnetostriction amount and is determined by Expression (A) below (e.g., Patent Literature 4 and Non-Patent Literature 2).

$$\text{Expression (A)}$$
$$3/2\lambda_{100} = \varepsilon(//) - \varepsilon(\perp)$$

$3/2\lambda_{100}$: the magnetostriction constant
$\varepsilon(//)$: the parallel magnetostriction amount when saturated by applying a magnetic field in parallel to the <100> direction
$\varepsilon(\perp)$: the perpendicular magnetostriction amount when saturated by applying a magnetic field perpendicularly to the <100> direction

The magnetostrictive characteristics of the Fe-Ga alloy are considered to affect the magnetostrictive and inverse magnetostrictive effects and the characteristics of magnetostrictive vibration power generation devices and are important parameters for device design (e.g., Non-Patent Literature 4). In particular, the magnetostriction constant depends on the Ga composition of the Fe-Ga alloy single crystal, and it is known that the magnetostriction constant reaches its maximum at Ga compositions of 18 to 19 at% and 27 to 28 at% (e.g., Non-Patent Literature 2), and it is desirable to use Fe-Ga alloys with such Ga concentrations for devices. Furthermore, in recent years, it has been reported that, in addition to the magnetostriction constant being large, a larger parallel magnetostriction amount tends to result in higher device characteristics such as output voltage (e.g., Non-Patent Literature 3).

A magnetostrictive vibration power generation device, for example, includes an Fe-Ga magnetostrictive member wound in a coil, as well as a yoke and a field permanent magnet (e.g., Patent Literature 5 and Non-Patent Literature 4). In this magnetostrictive vibration power generation device, as a mechanism, when the yoke as a movable part of the device is vibrated, the Fe-Ga magnetostrictive member fixed at the center of the yoke vibrates in tandem, the magnetic flux density of the coil wound on the Fe-Ga magnetostrictive member changes due to the reverse magnetostriction effect, and electromagnetic induction electromotive force is generated to generate power. In the magnetostrictive vibration power generation device, a force is applied in the long-side direction of the yoke to cause vibration, and thus the Fe-Ga magnetostrictive member for use in the device is desirably processed such that <100>, which is the easy axis of magnetization, is in the long-side direction.

Citation List

Patent Literature

[Patent Literature 1] Japanese Unexamined Patent Application Publication No. 2016-28831
[Patent Literature 2] Japanese Unexamined Patent Application Publication No. 2016-138028
[Patent Literature 3] Japanese Unexamined Patent Application Publication No. H04-108699
[Patent Literature 4] Japanese Translation of PCT Application Publication No. 2015-517024
[Patent Literature 5] WO2011/158473

Non-Patent Literature

[Non-Patent Literature 1] Etrema, State of the Art of Galfenol Processing.
[Non-Patent Literature 2] A. E. Clark et al., Appl. Phys. 93 (2003) 8621.
[Non-Patent Literature 3] Jung Jin Park, Suok-Min Na, Ganesh Raghunath, and Alison B. Flatau., AIP Advances 6, 056221 (2016).
[Non-Patent Literature 4] Toshiyuki Ueno, Journal of Japan Society for Precision Engineering Vol. 79, No. 4, (2013) 305-308.

Summary of Invention

Technical Problem

The device characteristics of magnetostrictive vibration power generation devices or the like are affected by the magnetostrictive characteristics of the magnetostrictive member, and thus the magnetostrictive member is required to have high magnetostrictive characteristics and a small variation in the magnetostrictive characteristics. Given these circumstances, it has been believed that if the crystal orientation of the single crystal of the Fe-Ga alloy is <100> and the Ga concentration is uniform, a magnetostrictive member with a uniform magnetostriction constant can be obtained. However, as described in Non-Patent Literature 3, it is disclosed that the device characteristics are affected by the parallel magnetostriction amount as well as the magnetostriction constant. Examinations by the inventors of the present invention have revealed that the magnetostrictive member manufactured as described above has a variation in the parallel magnetostriction amount (or the perpendicular magnetostriction amount) even if the magnetostriction constant is uniform.

Given these circumstances, an object of the present invention is to provide a magnetostrictive member having a high magnetostriction constant and a high parallel magnetostriction amount and small variations in the magnetostriction constant and the parallel magnetostriction amount among members and a method for manufacturing such a magnetostrictive member.

Solution to Problem

According to an aspect of the present invention, there is provided a magnetostrictive member containing an iron-based alloy crystal having magnetostrictive characteristics and being a plate-like body having front and back faces. In one of the front and back faces, a thickness and a surface roughness Ra of the magnetostrictive member satisfying Expression (1) below:

$$\text{Expression (1)}$$
$$\log Ra \geq 0.48t - 0.62$$

in Expression (1) above, log indicating a common logarithm, Ra the surface roughness (µm), and t the thickness of the magnetostrictive member (mm).

According to an aspect of the present invention, the surface roughness Ra may be 1.0 um or less when the thickness of the magnetostrictive member is 0.3 mm or more and 0.75 mm or less, and the surface roughness Ra may be 8.6 um or less when the thickness of the magnetostrictive member is more than 0.75 mm.

The surface roughness Ra may be 0.5 um or more when the thickness of the magnetostrictive member is more than 0.3 mm and 0.75 or less, the surface roughness Ra may be 1.0 um or more when the thickness of the magnetostrictive member is more than 0.75 mm and 1.0 mm or less, the surface roughness Ra may be 1.3 um or more when the thickness of the magnetostrictive member is more than 1.0 mm and 1.5 mm or less, the surface roughness Ra may be 2.5 pm or more when the thickness of the magnetostrictive member is more than 1.5 mm and 2.0 mm or less, and the surface roughness Ra may be 4.0 um or more when the thickness of the magnetostrictive member is more than 2.0 mm and 2.5 mm or less.

The thickness and the surface roughness Ra of the magnetostrictive member may satisfy Expression (2) below when the thickness of the magnetostrictive member is 0.5 mm or more and 0.75 mm or less,

the thickness and the surface roughness Ra of the magnetostrictive member may satisfy Expression (3) below when the thickness of the magnetostrictive member is more than 0.75 mm and 1.0 mm or less, and
the thickness and the surface roughness Ra of the magnetostrictive member may satisfy Expression (4) below when the thickness of the magnetostrictive member is more than 1.0 mm and 0.1.5 mm or less.

$$\text{Expression (2)}$$
$$\log Ra \leq 0.92t - 0.45$$

$$\text{Expression (3)}$$
$$\log Ra \leq 1.48t - 1.01$$

$$\text{Expression (4)}$$
$$\log Ra \leq 0.40t - 0.20$$

In Expressions (2) to (4) above, log indicates a common logarithm, Ra the surface roughness Ra ($\mu$m), and t the thickness of the magnetostrictive member (mm).

A parallel magnetostriction amount/magnetostriction constant ratio of the magnetostrictive member may be 80% or more. The magnetostriction constant may be 250 ppm or more and the parallel magnetostriction amount may be 250 ppm or more. The iron-based alloy may be an Fe-Ga alloy single crystal. The thickness of the magnetostrictive member may be 0.3 mm or more and 2.5 mm or less.

According to an aspect of the present invention, there is provided a method for manufacturing a magnetostrictive member containing an iron-based alloy crystal having magnetostrictive characteristics and being a plate-like body having front and back faces, the method including processing at least one of the front and back faces such that a thickness and a surface roughness Ra of the magnetostrictive member satisfy Expression (1) below:

$$\text{Expression (1)}$$
$$\log Ra \geq 0.48t - 0.62$$

in Expression (1) above, log indicating a common logarithm, Ra the surface roughness ($\mu$m), and t the thickness of the magnetostrictive member (mm).

According to an aspect of the present invention, the processing may be grinding. The grinding may be surface grinding. The surface grinding may be performed using a grinding wheel of #40 or more and #500 or less and may include selecting a grinding wheel of a number causing the thickness and the surface roughness Ra of the magnetostrictive member to satisfy Expression (1). The processing may include processing to achieve a magnetostriction constant of 250 ppm or more and a parallel magnetostriction amount of 250 ppm or more.

Advantageous Effects

The magnetostrictive member of an aspect of the present invention has the characteristics of a high magnetostriction constant and a high parallel magnetostriction amount and small variations in the magnetostriction constant and the parallel magnetostriction amount among members. The method for manufacturing a magnetostrictive member of an aspect of the present invention can easily manufacture a magnetostrictive member having a high magnetostriction constant and a high parallel magnetostriction amount and small variations in the magnetostriction constant and the parallel magnetostriction amount among members.

Further, the effect of the modification of the magnetostriction constant and the parallel magnetostriction amount can be expressed stably at a high level by making the surface roughness of the magnetostrictive member in a certain direction in a certain range with respect to the plate thickness of the magnetostrictive member.

Brief Description of the Drawings

Fig. 1 is a diagram of an example of a magnetostrictive member according to an embodiment.
Fig. 2 is a flowchart of an example of a method for manufacturing a magnetostrictive member according to the embodiment.
Fig. 3 is a diagram of a first example of a single crystal, a thin plate member, and a magnetostrictive member.
Fig. 4 is a diagram of a second example of the single crystal, the thin plate member, and the magnetostrictive member.
Fig. 5 is a diagram of a third example of the single crystal, the thin plate member, and the magnetostrictive member.
Fig. 6 is a diagram of a strain gauge method used in examples.
Fig. 7 is a diagram showing the relation between the plate thickness and the surface roughness of the magnetostrictive member.
Fig. 8 is a diagram showing the relation between the plate thickness and the surface roughness of the magnetostrictive member.

Description of Embodiments

The following describes specific embodiments of the present invention in detail. The present invention is not limited to the following embodiments and can be modified as appropriate to the extent that the gist of the present invention is not changed. Part or the whole of each of the drawings is schematically described and is described on different scales as appropriate. In the following description, the description "A to B" means "A or more and B or less."

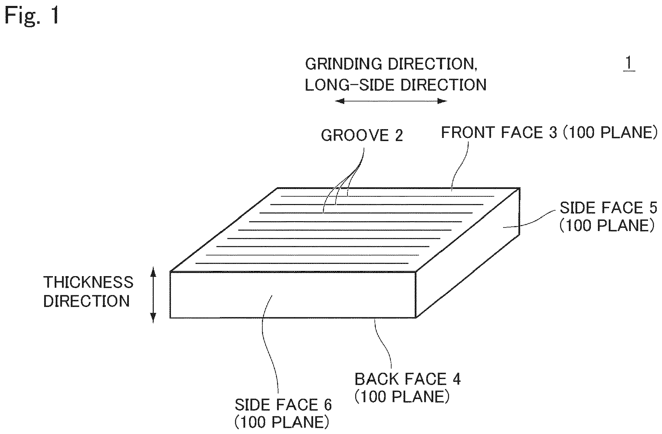

The following describes a magnetostrictive member and a method for manufacturing a magnetostrictive member of the present embodiment. The following first describes the magnetostrictive member of the present embodiment. Fig. 1 is a diagram of an example of the magnetostrictive member according to the embodiment.

As illustrated in Fig. 1, this magnetostrictive member 1 is a plate-like body. The plate-like body has a front face 3 and a back face 4. The front face 3 and the back face 4 are suitably parallel to each other but are not necessarily parallel to each other.

The magnetostrictive member 1 is formed of a crystal of an iron-based alloy. The iron-based alloy is not limited to a particular alloy so long as it has magnetostrictive characteristics. The magnetostrictive characteristics mean characteristics causing a shape change when a magnetic field is applied. The iron-based alloy is, for example, an alloy such as Fe-Ga, Fe-Ni, Fe-Al, Fe-Co, Tb-Fe, Tb-Dy-Fe, Sm-Fe, or Pd-Fe. The alloys may be alloys with a third component added. The Fe-Ga alloy, for example, may be an alloy with Ba, Cu, or the like added. Among these iron-based alloys, the Fe-Ga alloy has larger magnetostrictive characteristics and is easier to process than other alloys and thus has been applied to materials for vibration power generation in the energy harvesting field, wearable terminals, sensors, and the like. In the following description, an example of a configuration in which the magnetostrictive member 1 is formed of a single crystal of the Fe-Ga alloy will be described as an example of the magnetostrictive member 1.

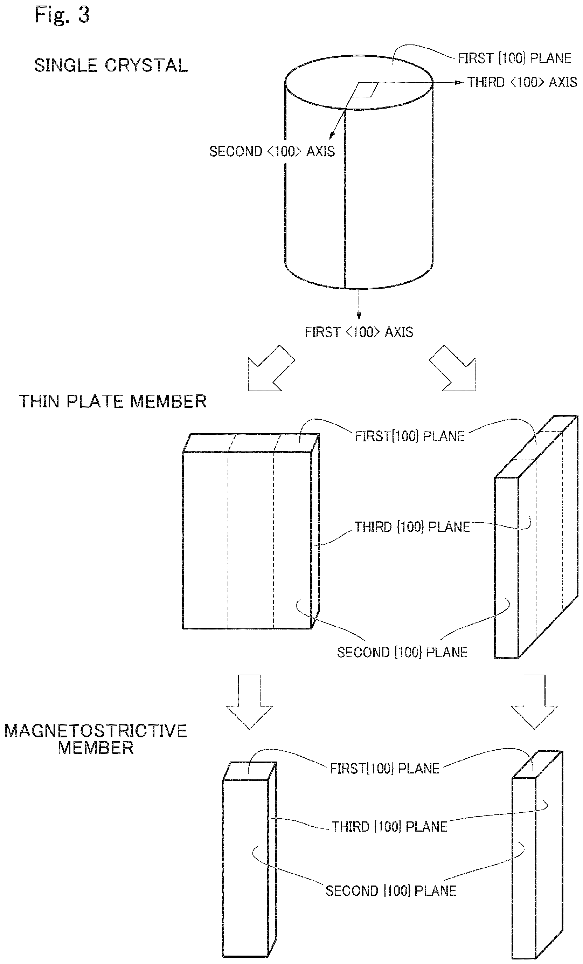

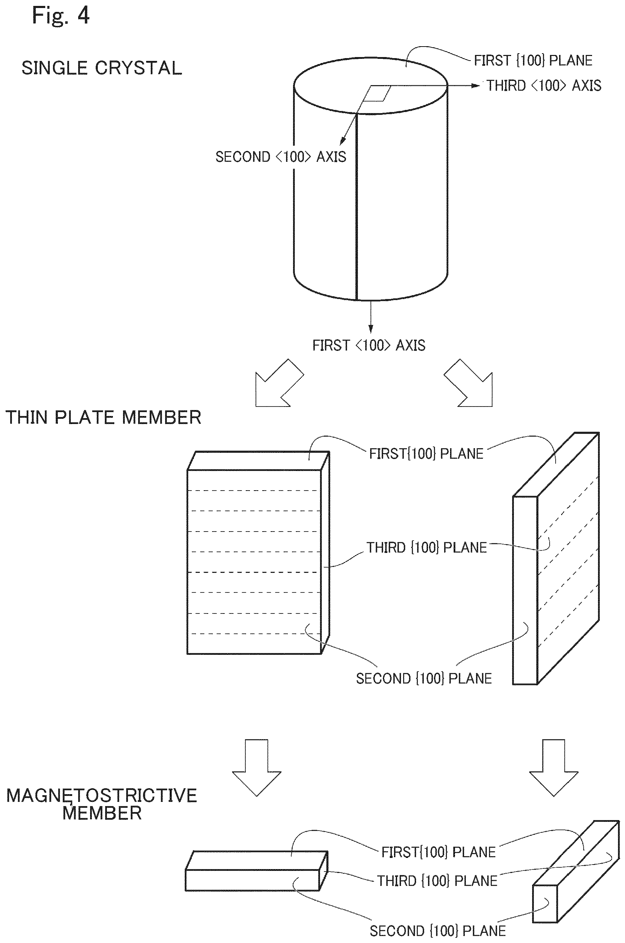

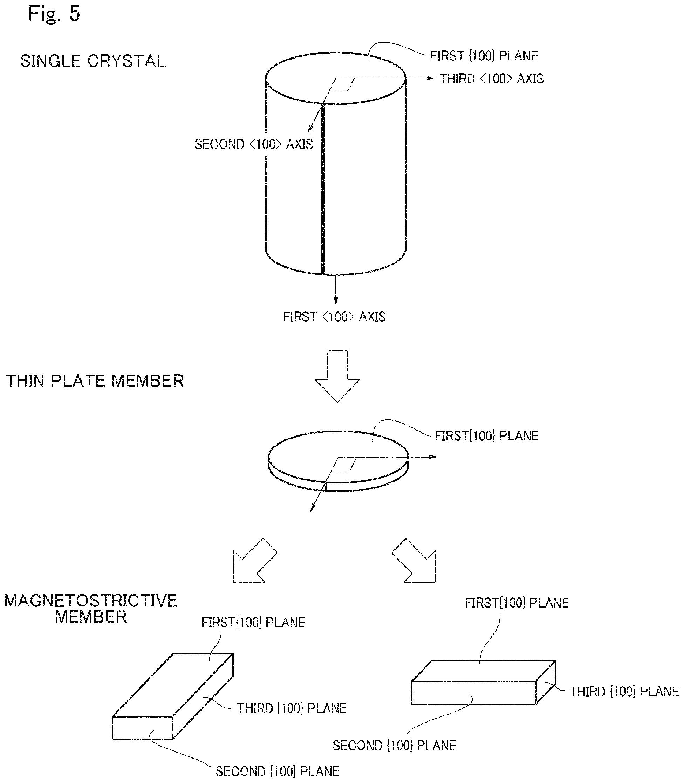

The single crystal of the Fe-Ga alloy has a body-centered cubic lattice structure and is based on the fact that first to third <100> axes (see Fig. 3 to Fig. 5) of the directional indices in the Miller indices are equivalent and first to third {100} planes (see Fig. 3 to Fig. 5) of the plane indices in the Miller indices are equivalent (i.e., (100), (010), and (001) are equivalent).

In addition, the Fe-Ga alloy has the characteristic of exhibiting large magnetic distortion in a specific orientation of the crystal. When this characteristic is used for a magnetostrictive vibration power generation device, it is desirable to match the direction in which the magnetostriction of the magnetostrictive member 1 is required in the device and the orientation (direction) in which the magnetic strain of the crystal is maximum with each other. Specifically, as described above, it is desirable to set the <100> direction, which is the easy direction of magnetization in the single crystal, to the long-side direction of the magnetostrictive member 1. Setting the <100> direction, which is the easy direction of magnetization in the single crystal, to the long-side direction of the magnetostrictive member 1 can be performed, for example, by calculating the crystal orientation of the single crystal by known crystal orientation analysis and cutting the single crystal on the basis of the calculated crystal orientation of the single crystal.

The crystal that can be used for the magnetostrictive member 1 of the present embodiment may be the single crystal or a polycrystal. The use of the single crystal is more advantageous than the polycrystal in order to increase the orientation integration in the <100> direction and to enhance characteristics as a magnetostrictive material. The polycrystal can be produced at low cost, although its magnetostrictive characteristics are lower than those of the single crystal, and thus the polycrystal may also be used.

The magnetostrictive member 1 is used, for example, as materials (components) for vibration power generation devices in the energy harvesting field and materials (components) for wearable terminals, sensors, and the like. For example, the magnetostrictive vibration power generation device as disclosed in Patent Literature 5 above includes a coil, an Fe-Ga alloy magnetostrictive member wound in the coil, a yoke, and a field permanent magnet. In this magnetostrictive vibration power generation device, as a mechanism, when the yoke as a movable part of the device is vibrated, the magnetostrictive member fixed at the central part of the yoke vibrates in tandem, the magnetic flux density of the coil wound on the magnetostrictive member changes due to the reverse magnetostriction effect, and electromagnetic induction electromotive force is generated to generate power. When used on such a mechanism, it is suitable that the shape of the magnetostrictive member 1 is like a thin plate and is set to an elongated rectangular shape in a plan view. The thickness of the magnetostrictive member 1 is not limited to a particular thickness. The lower limit of the thickness is suitably 0.3 mm or more and more suitably 0.5 mm or more. The upper limit of the thickness of the magnetostrictive member 1 is suitably less than 3 mm, more suitably 2.5 mm or less, and even more suitably 2 mm or less. The thickness of the magnetostrictive member 1 is suitably 0.3 mm or more and less than 3 mm and more suitably 0.5 mm or more and 2.5 mm or less. The mechanism of power generation by the magnetostrictive member 1 is, as described above, a mechanism to generate power by the reverse magnetostriction effect by applying stress to the magnetostrictive member (vibration). When the thickness of the magnetostrictive member 1 is less than 0.3 mm, it is easily damaged during vibration. When the thickness of the magnetostrictive member 1 exceeds 2 mm, on the other hand, the stress due to vibration is required to be increased, resulting in lower efficiency.

The shape and the dimensions of the magnetostrictive member 1 are not limited to particular ones. The shape and the dimensions of the magnetostrictive member 1 are set as appropriate in accordance with the size of an objective device. For example, the magnetostrictive member 1 may have a rectangular shape (including a square shape) and need not have a rectangular shape in a plan view. For example, the shape of the magnetostrictive member 1 may be elliptic, track-shaped, or irregular in a plan view. When the shape of the magnetostrictive member 1 is other than the rectangular shape in a plan view, the long-side direction is a long-diameter direction, a long-axis direction, or the like, whereas the short-side direction is a direction orthogonal to the long-side direction.

As described above, the inventors of the present invention produced a plurality of plate-like magnetostrictive members formed of a single crystal of the Fe-Ga alloy, with the {100} plane as the principal plane, and with a rectangular shape in a plan view with the <100> direction, which is the easy direction of magnetization, as the long-side direction of the magnetostrictive member. Checking the magnetostrictive characteristics of the magnetostrictive members produced by being cut out of the single crystal of the Fe-Ga alloy with a uniform Ga concentration revealed that the produced magnetostrictive members had a large variation in the parallel magnetostriction amount, although they had a high-level magnetostriction constant. After further examinations, it was also found out that the magnetostriction constant and the parallel magnetostriction amount were related to a grinding direction of the magnetostrictive member (a grinding direction) and were also related to the plate thickness of the magnetostrictive member. The present invention has been made on the basis of the above findings.

The following gives a more detailed description.

As illustrated in Fig. 3, a thin plate member was cut out by cutting the grown single crystal with a free abrasive grain type multi-wire saw so as to be parallel to the first <100> axial direction (the single crystal growth direction) and parallel to the third <100> axial direction. The thickness of the thin plate member was set to be 0.2 mm thicker than a certain plate thickness so that the thickness after surface grinding would be 0.3 mm to 3.0 mm. Next, both faces of the thin plate member were mirror-polished, and the thin plate member was cut into a size of 10 mm × 10 mm. Magnetostrictive characteristics were measured for the cut-out samples, and five samples were selected for each thin plate member so as to include parts larger and smaller in the parallel magnetostriction amount. In this process, a direction parallel to the first <100> axial direction (the single crystal growth direction) was defined as the parallel magnetostriction amount.

Next, surface grinding was performed while changing the grain size (number) of the grinding wheel so as to achieve the certain thickness. In this process, the grinding direction of the surface grinding (a direction in which a plurality of grooves extend) was the first <100> axial direction (the single crystal growth direction). Subsequently, the magnetostrictive characteristics of the samples with the front and back faces ground were measured.

For the magnetostrictive characteristics, a strain gauge was attached to the surface of the magnetostrictive member sample to measure the magnetostriction constant and the parallel magnetostriction amount in the growth axis direction before and after surface grinding. Tables 1 to 3 list the results. The measurement of the magnetostriction constant and the parallel magnetostriction amount will be described below.

As can be seen from Table 1, it is found that in the samples obtained by processing the grown crystal from the thin plate member, for example, as in No. 1 to No. 5 of Example 1, in the samples with the mirror-finished front and back faces, there are variations of 13 to 279 ppm in the parallel magnetostriction amount, although the magnetostriction constant is 290 ppm to 301 ppm. In Example 2 too, there are variations of 102 to 290 ppm in the parallel magnetostriction amount, although the magnetostriction constant is 295 ppm to 301 ppm. The other examples are similar and have tendency that there are variations in the parallel magnetostriction amount, although the magnetostriction constant is stable.

Next, a plurality of grooves 2 were formed on the front and back faces on the samples with the mirror-finished front and back faces by surface grinding. The grinding direction (the direction in which the grooves extend) was the first <100> axial direction (the single crystal growth direction), which was the same direction as the direction in which the parallel magnetostriction amount is measured. Consequently, as shown in Example 1, in No. 3 and No. 4 samples with low parallel magnetostriction amounts before grinding (before forming the grooves 2), the parallel magnetostriction amounts after grinding (after forming the grooves 2) are modified to change from a low level to a high level (297 ppm and 300 ppm). The parallel magnetostriction amount markedly increases by forming the grooves 2. In No. 1, No. 2, and No. 5 samples in Example 1, the parallel magnetostriction amounts are 289 ppm to 299 ppm, and the values of the parallel magnetostriction amounts remain stable at a high level. Consequently, it was found that the magnetostriction constants and the parallel magnetostriction amounts of No. 1 to No. 5 samples in Example 1, which were subjected to surface grinding in the same direction as the measurement direction of the parallel magnetostriction amounts, were modified to be stable at a high level with small variations among the members (among the samples). This trend was observed in the other examples as well.

Further, it was found that this effect of modification had an appropriate value for the surface roughness Ra in a direction perpendicular to the grinding direction (hereinafter, may be abbreviated as a "vertical direction") (hereinafter, may be abbreviated as "surface roughness Ra") on the same face depending on the plate thickness. It was found that the surface roughness Ra was suitably set to be relatively small when the plate thickness was small, whereas the surface roughness Ra was suitably set to be relatively large when the plate thickness was large.

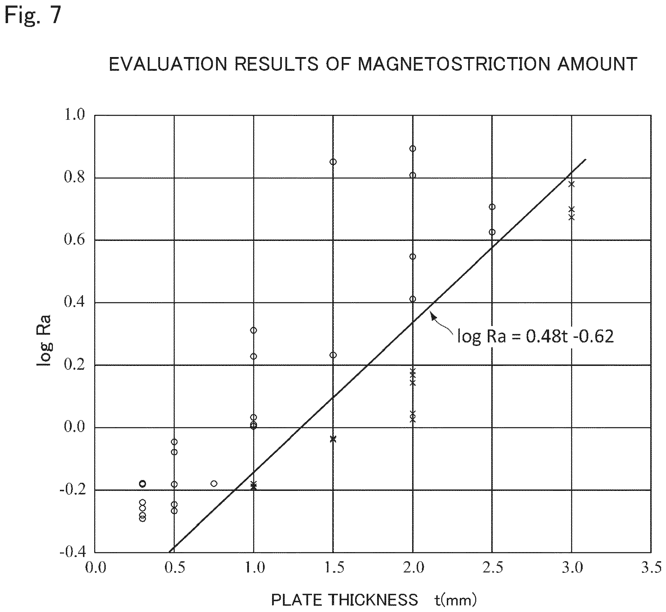

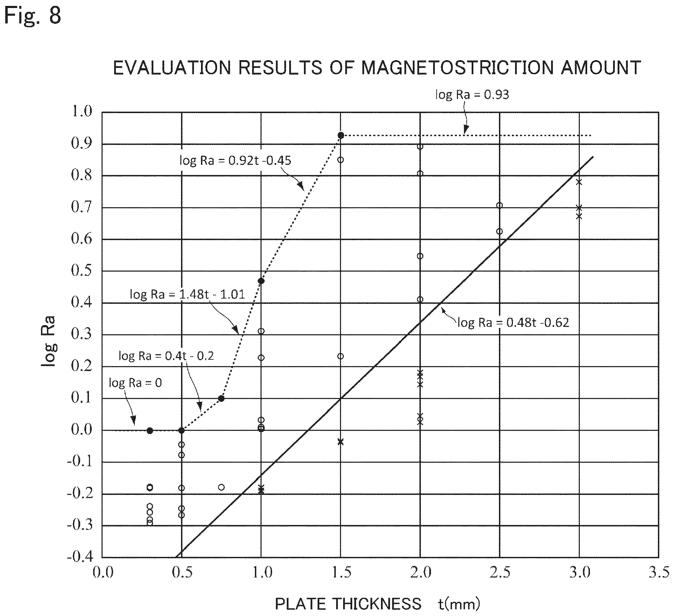

In Example 1 to Example 12 and Comparative Example 1 to Comparative Example 5, the magnetostriction constant and the parallel magnetostriction amount were measured before and after processing with surface grinding by setting the thickness of the magnetostrictive member from 0.3 mm to 3 mm and changing the grain size (number) of the grinding wheel, and the surface roughness Ra after the processing was measured. Tables 1 to 3 list the results. In the measurement of the surface roughness Ra, the measurement direction was the direction perpendicular to the grinding direction, five points were measured from the surface of the magnetostrictive member, and the average thereof was defined as the surface roughness Ra of the member. In each of the examples and the comparative examples, five samples each were selected so as to include parts larger and smaller in the parallel magnetostriction amount in the measurement before the processing. As described above, samples with higher parallel magnetostriction amounts before the processing remain stable at a high level even after the processing, while samples with lower parallel magnetostriction amounts before the processing are modified to have higher parallel magnetostriction amounts by surface grinding. Thus, in this case, to clarify the effect of modification, the samples were limited only to ones in which the parallel magnetostriction amount before the processing was less than 80% of the magnetostriction constant. Figs. 7 and 8 illustrate the results. In Figs. 7 and 8, the surface roughness Ra on the vertical axis is represented as log (common logarithm). In Figs. 7 and 8, o marks show examples producing the modification effect, whereas x marks show comparative examples producing a smaller modification effect with the parallel magnetostriction amount being less than 80% of the magnetostriction constant after the processing.

As can be seen from Fig. 7, it was found that the effect of modification involved an appropriate surface roughness Ra depending on the plate thickness. It was found that when the plate thickness was small, the effect of modification was achievable even with a small surface roughness Ra. It was found that as the plate thickness increased, the effect of modification tended to be smaller unless the surface roughness Ra was increased. There is a correlation between the plate thickness and the surface roughness Ra of the magnetostrictive member for this effect of modification. As indicated by the straight line in Fig. 7, a result was given in which Expression (1) below was satisfied when the effect of modification was good.

$$\text{Expression (1)}$$

$$\log Ra \geq 0.48t - 0.62$$

In Expression (1), log indicates a common logarithm, Ra the surface roughness ($\mu$m), and t the thickness of the magnetostrictive member (mm).

When grinding is performed with a surface grinder or the like, the surface roughness Ra in a perpendicular direction perpendicular to the grinding direction (hereinafter, may be referred to simply as the perpendicular direction) is larger. Thus, the value of the surface roughness Ra in the present embodiment is a value in the perpendicular direction to the grinding direction. That is, the surface roughness Ra in the magnetostrictive member 1 of the present embodiment and a method for manufacturing a magnetostrictive member of the present embodiment described below is a value in a direction with the maximum value within one face.

That is, the magnetostrictive member 1 of the present embodiment contains an iron-based alloy crystal having magnetostrictive characteristics and is a plate-like body having front and back faces, and the thickness and the surface roughness Ra of the magnetostrictive member satisfy Expression (1) above. With the above configuration, the magnetostrictive member 1 of the present embodiment has the characteristics of a high magnetostriction constant and a high parallel magnetostriction amount and small variations in the magnetostriction constant and the parallel magnetostriction amount among members. In the magnetostrictive member 1 of the present embodiment and the method for manufacturing a magnetostrictive member of the present embodiment described below, the measurement direction of the parallel magnetostriction amount is the grinding direction.

If Expression (1) above is not satisfied, the effect of modification will not be achievable. As shown in Comparative Examples 1 to 5 in Table 3, high parallel magnetostriction amounts before the processing remain at a high level after the processing.

Thus, when the magnetostrictive member 1 is subjected to grinding such as surface grinding, processing stress is placed on the surface of the magnetostrictive member 1. In particular, larger tensile stress occurs in the direction perpendicular to the grinding direction. The variation in the magnetostrictive characteristics of the magnetostrictive member 1 is thought to be due to variations in the direction of magnetization. It is presumed that the above modification takes place because the tensile stress is aligned in the direction perpendicular to the grinding direction on the surface of the magnetostrictive member 1, and this stress causes the direction of magnetization of the magnetostrictive member 1 to align in a certain direction. As the plate thickness of the magnetostrictive member 1 increases, the volume in the direction of magnetization that needs to be aligned increases (in accordance with the increased thickness). Thus, to achieve the above modification effect, the tensile stress in the direction perpendicular to the grinding direction on the surface of the magnetostrictive member 1 is required to be larger, and consequently the surface roughness Ra becomes large. When the surface roughness Ra is so small that Expression (1) above is not satisfied, the processing stress on the surface becomes small, and consequently, the modification effect is insufficient and the condition is similar to that before the processing.

There is no particular limitation on the upper limit of the surface roughness Ra of the magnetostrictive member 1, but when the plate thickness of the magnetostrictive member 1 is 1.2 mm or less, if the surface roughness is large, too much processing stress may be applied to the surface of the magnetostrictive member 1, and the magnetostriction constant itself may reduce.

Even when the plate thickness of the magnetostrictive member is 2.5 mm or more, it is possible to address the situation by increasing the surface roughness Ra. However, care should be taken because when the plate thickness of the magnetostrictive member increases, when used for vibration power generation or the like, the stress due to vibration is required to be increased, resulting in lower efficiency.

Given these circumstances, the surface roughness Ra of the magnetostrictive member 1 is suitably 1.0 um or less when the thickness of the magnetostrictive member is 0.3 mm or more and 0.75 mm or less, and the surface roughness Ra is suitably 8.6 um or less when the thickness of the magnetostrictive member is more than 0.75 mm.

The surface roughness Ra is suitably 0.5 um or more when the thickness of the magnetostrictive member is more than 0.3 mm and 0.75 or less, the surface roughness Ra is suitably 1.0 um or more when the thickness of the magnetostrictive member is more than 0.75 mm and 1.0 mm or less, the surface roughness Ra is suitably 1.3 um or more when the thickness of the magnetostrictive member is more than 1.0 mm and 1.5 mm or less, the surface roughness Ra is suitably 2.5 um or more when the thickness of the magnetostrictive member is more than 1.5 mm and 2.0 mm or less, and the surface roughness Ra is suitably 4.0 um or more when the thickness of the magnetostrictive member is more than 2.0 mm and 2.5 mm or less. With this configuration, the effect of modification can be expressed more surely.

As more suitable ranges, as indicated by the dotted line in Fig. 8, the thickness and the surface roughness Ra of the magnetostrictive member more suitably satisfy Expression (2) below when the thickness of the magnetostrictive member is 0.5 mm or more and 0.75 mm or less, the thickness and the surface roughness Ra, in the direction perpendicular to the grinding direction, of the magnetostrictive member more suitably satisfy Expression (3) below when the thickness of the magnetostrictive member is more than 0.75 mm and 1.0 mm or less, and the thickness and the surface roughness Ra of the magnetostrictive member more suitably satisfy Expression (4) below when the thickness of the magnetostrictive member is more than 1.0 mm and 1.5 mm or less. With this configuration, the effect of modification can be expressed more surely.

```
Expression (2)

log Ra ≤ 0.92t - 0.45
```

Expression (3)

log Ra ≤ 1.48t - 1.01

Expression (4)

log Ra ≤ 0.40t - 0.20

In Expressions (2) to (4) above, log indicates a common logarithm, Ra the surface roughness Ra ($\mu$m) in the direction perpendicular to the grinding direction, and t the thickness of the magnetostrictive member (mm).

Thus, by setting the surface roughness Ra within the above ranges with respect to the thickness of the magnetostrictive member 1 described above, the effect of the modification of the magnetostriction constant and the parallel magnetostriction amount can be expressed stably at a high level.

From the viewpoint of expressing the modification effect by an easier method of manufacture and surely, the magnetostrictive member 1 suitably has a ground surface subjected to grinding, and it is particularly suitably a surface subjected to surface grinding. The grinding is suitably processing performing grinding in one direction. That is, the magnetostrictive member 1 suitably includes a processed surface subjected to grinding in one direction (a one-directionally ground surface) and more suitably includes a processed surface subjected to surface grinding (a surface ground surface). The grinding direction in the magnetostrictive member 1 is not limited to a particular direction but is suitably a direction along the long-side direction of the magnetostrictive member 1. In this example, the direction along the long-side direction includes directions intersecting the long-side direction within 40°.

Such a high modification effect that the ratio of the parallel magnetostriction amount to the magnetostriction constant after modification (parallel magnetostriction amount/magnetostriction constant) is suitably 80% and more suitably 90% or more can be obtained. Further, the magnetostriction constant itself can be a stable value at a high level of 250 ppm or more in the case of Fe-Ga alloys, for example.

As described above, the magnetostrictive member 1 of the present embodiment contains an iron-based alloy crystal having magnetostrictive characteristics and is a plate-like body having the front and back faces 3 and 4. In one of the front and back faces, the thickness and the surface roughness Ra of the magnetostrictive member satisfy Expression (1) above. In the magnetostrictive member 1 of the present embodiment, any configuration other than the above is optional. With the above configuration, the magnetostrictive member 1 of the present embodiment has the characteristics of a high magnetostriction constant and a high parallel magnetostriction amount and small variations in the magnetostriction constant and the parallel magnetostriction amount among members. Further, the magnetostrictive member 1 of the present embodiment can express the effect of the modification of the magnetostriction constant and the parallel magnetostriction amount stably at a high level by making the surface roughness of the magnetostrictive member in a certain direction in a certain appropriate range with respect to the plate thickness of the magnetostrictive member. For example, the magnetostrictive member 1 of the present embodiment has the characteristics of a magnetostriction constant of suitably 200 ppm or more, more suitably 250 ppm or more, more suitably 280 ppm or more, and more suitably 290 ppm or more. The magnetostrictive member 1 has the characteristics of a parallel magnetostriction constant of suitably 200 ppm or more, more suitably 250 ppm or more, more suitably 270 ppm or more, more suitably 280 ppm or more, and more suitably 290 ppm or more. The magnetostrictive member 1 has a parallel magnetostriction amount/magnetostriction constant ratio of suitably 80% or more, more suitably 90% or more, and more suitably 95% or more. The magnetostrictive member 1 of the present embodiment has a high magnetostriction constant as described above and can thus be suitably used as an end product of a member (material) exhibiting excellent magnetostriction and reverse magnetostriction effects.

The following describes a method for manufacturing a magnetostrictive member of the present embodiment.

The method for manufacturing a magnetostrictive member of the present embodiment is a method for manufacturing the magnetostrictive member 1 of the present embodiment described above. In the method for manufacturing a magnetostrictive member of the present embodiment, the magnetostrictive member contains and iron-based alloy crystal having magnetostrictive characteristics and is a plate-like body having front and back faces. The method includes processing at least one of the front and back faces 3 and 4 such that the thickness and the surface roughness Ra of the magnetostrictive member satisfy Expression (1) below:

Expression (1)

log Ra ≥ 0.48t - 0.62

In Expression (1) above, log indicates a common logarithm, Ra the surface roughness ($\mu$m), and t the thickness of the magnetostrictive member (mm). In the following description, a method for manufacturing the magnetostrictive member 1 from a single crystal ingot of an Fe-Ga alloy will be described as an example, but the method for manufacturing a magnetostrictive member of the present embodiment is not limited to the following description. It is assumed that any description herein that is applicable to the method for manufacturing a magnetostrictive member of the present embodiment is also applicable to the method for manufacturing a magnetostrictive member of the present embodiment. It is assumed that any description in the method for manufacturing a magnetostrictive member of the present embodiment that is applicable to the magnetostrictive member of the present embodiment is also applicable to the magnetostrictive member of the present embodiment. The method for manufacturing the magnetostrictive member 1 of the present embodiment is not limited to the method for manufacturing a magnetostrictive member of the present embodiment described below but may be achieved by other methods of manufacture.

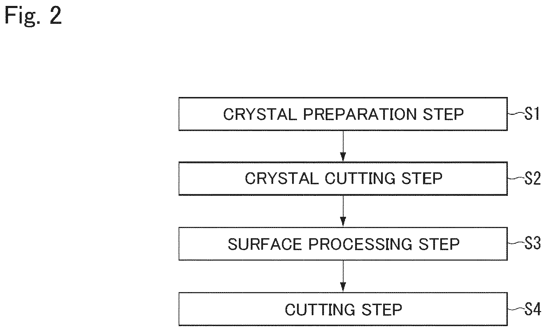

Fig. 2 is a flowchart of an example of the method for manufacturing a magnetostrictive member of the present embodiment. Fig. 3 to Fig. 5 are diagrams of first to third examples of a single crystal, a thin plate member, and a magnetostrictive member. This method for manufacturing a magnetostrictive member of the present embodiment includes a crystal preparation step (Step S1), a crystal cutting step (Step S2), a surface processing step (Step S3), and a cutting step (Step S4) .

In the method for manufacturing a magnetostrictive member of the present embodiment, first, in the crystal preparation step (Step S1), a crystal of an iron-based alloy having magnetostrictive characteristics is prepared. The crystal to be prepared may be a single crystal or a polycrystal. The crystal to be prepared may be a grown one or a commercially available one. For example, in the crystal preparation step, a single crystal of an Fe-Ga alloy is prepared. The method for growing the single crystal of the Fe-Ga alloy is not limited to a particular method. The method for growing the single crystal of the Fe-Ga alloy may be the pull-up method or the unidirectional solidification method. For example, the Cz method can be used as the pull-up method, and the VB method, the VGF method, the micro pull-down method, and the like can be used as the unidirectional solidification method.

For the single crystal of the Fe-Ga alloy, the magnetostriction constant is maximized by setting the content of gallium to 18.5 at% or 27.5 at%. For this reason, the single crystal of the Fe-Ga alloy is grown so as to have a content of gallium of suitably 16.0 to 20.0 at% or 25.0 to 29.0 at% and more suitably 17.0 to 19 at% or 26.0 to 28.0 at%. The shape of the grown single crystal is not limited to a particular shape and may be cylindrical or quadrangular prismatic, for example. The grown single crystal may be made into a cylindrical single crystal by cutting a seed crystal, a diameter-increased part, a shoulder part (a part with an increased diameter from the seed crystal to a predetermined single crystal), or the like with a cutting apparatus, if necessary. The size of the single crystal to be grown is not limited to a particular size so long as it is large enough to ensure the magnetostrictive member in a predetermined direction. When the single crystal of the Fe-Ga alloy is grown, it is grown using a seed crystal processed with the upper face or the lower face of the seed crystal to be the {100} plane so that the growth axis direction is <100>. In the Fe-Ga alloy single crystal to be grown, the crystal is grown in a direction perpendicular to the upper face or the lower face of the seed crystal, and the orientation of the seed crystal is inherited.

Following the crystal preparation step (Step S1), the crystal cutting step (Step S2) is performed. The crystal cutting step is a step for cutting the crystal to produce a thin plate member. The thin plate member is a member to be the material of the magnetostrictive member 1 of the present embodiment. The crystal cutting step is, for example, a step for cutting the single crystal of the Fe-Ga alloy having magnetostrictive characteristics using a cutting apparatus to produce a thin plate member with the {100} plane as its principal plane. As the cutting apparatus, a cutting apparatus such as a wire electric discharge machine, an inner peripheral blade cutting apparatus, or a wire saw can be used. Among these, the use of a multi-wire saw is particularly suitable because it can cut a plurality of thin plate members at the same time. The cutting direction of the single crystal in the case of the single crystal of the Fe-Ga alloy is <100>, and cutting is performed such that a cut plane, that is, the principal plane of the thin plate member is the {100} plane. The cutting direction of the single crystal is not limited to a particular direction. The cutting direction of the single crystal may be a perpendicular direction or a parallel direction with respect to the growing direction of the single crystal (the direction in which the crystal is grown) as illustrated in Fig. 3 to Fig. 5, for example.

Following the crystal cutting step (Step S2), the surface processing step (Step S3) is performed. In the surface processing step, as described above, at least one of the front and back faces 3 and 4 is processed such that the relation between the plate thickness and the surface roughness Ra satisfies the Expression (1) above. With the surface processing step, the magnetostrictive member 1 of the present embodiment can be obtained. The processing is suitably grinding and more suitably surface grinding. For example, the surface processing step forms a plurality of grooves 2 on at least one of the front face 3 and the back face 4 of the obtained thin plate member. The direction in which the grooves 2 are formed is not limited to a particular direction, but in the surface processing step, the grooves 2 are suitably formed in the thin plate member such that when the thin plate member is finally cut and made into the magnetostrictive member 1, the grooves 2 extending in the long-side direction of the magnetostrictive member 1 are formed. As described above, the grooves 2 can be formed by performing the surface grinding on at least one of the front and back faces of the thin plate member obtained by the crystal cutting step. In this case, the grooves 2 are grooves extending in the grinding direction. The following describes an example in which the surface processing step is performed by the surface grinding on the thin plate member. With the grooves 2 formed by the surface grinding, the effect of the modification of the magnetostriction constant and the parallel magnetostriction amount can be efficiently expressed.

The surface grinding is performed using a surface grinder. From the viewpoint of efficiently expressing the effect of the modification of the magnetostriction constant and the parallel magnetostriction amount, the surface grinding is suitably performed such that the direction of the grooves 2 (grinding marks) formed on the thin plate member is a direction parallel to the long-side direction of the magnetostrictive member 1. For this reason, the grinding marks are suitably straight. To make the grinding marks straight, the surface grinder is suitably of a type in which the moving direction of a grinding wheel or a processing table is straight, and the surface grinder of a type including a flat grinding wheel and in which the processing table reciprocates is suitably used. The surface grinder including a cup grinding wheel and in which the processing table rotates can also be used, but when using such a surface grinder, the grinding marks are curved, and thus it is suitable to set the curvature of the grinding marks to be small (less curved).

The grinding marks are required to be formed on the surface of the magnetostrictive member 1. For this reason, when processing is performed by thickness adjustment or the like of the thin plate member, processing such as the surface grinding may be performed after predetermined processing is performed with a processing machine other than the surface grinder such as a double-sided lapping apparatus or a surface grinder including a cup grinding wheel or the like. The surface of the thin plate member (the magnetostrictive member) may be finished to be a mirror surface by performing polishing as in a conventional manner, followed by the processing such as the surface grinding. From the viewpoint of efficiently expressing the effect of the modification of the magnetostriction constant and the parallel magnetostriction amount, the processing such as the surface grinding is suitably performed on both the front and back faces of the thin plate member.

The grinding wheel used for the surface grinding is selected to be within the ranges of the surface roughness Ra described above in accordance with the plate thickness of the magnetostrictive member. For example, the number of the grinding wheel for processing the magnetostrictive member with a surface grinder is #200 or more and #500 or less when the plate thickness of the magnetostrictive member is 0.3 mm to 0.75 mm, the number of the grinding wheel is #60 or more and #100 or less when the plate thickness of the magnetostrictive member is 1.0 mm, the number of the grinding wheel is #40 or more and #50 or less when the plate thickness of the magnetostrictive member is 2.0 mm, or the like. The number of the grinding wheel is suitably #40 or less when the plate thickness of the magnetostrictive member is 2.5 mm or more.

The grooves 2 are suitably formed in the magnetostrictive member 1 such that the magnetostriction constant and the parallel magnetostriction amount are in the ranges described above. For example, the grooves 2 are suitably formed in the magnetostrictive member 1 such that the magnetostriction constant is 200 ppm or more and the parallel magnetostriction amount is 200 ppm or more. Further, as described above, the roughness (number) of the grinding wheel is appropriately selected in accordance with the plate thickness of the magnetostrictive member such that the relation between the plate thickness and the surface roughness Ra is in the ranges described above, thereby suitably forming the magnetostrictive member 1 so as to have a magnetostriction constant of 250 ppm or more and a parallel magnetostriction amount of 250 ppm or more. The grooves 2 with the surface roughness Ra, the magnetostriction constant, and the parallel magnetostriction amount in the suitable ranges can be formed by the surface grinding described above. The surface processing step may be performed by a method other than the surface grinding if it can form the grooves 2 on at least one of the front face 3 and the back face 4 of the obtained thin plate member. For example, the thin plate member may be produced with a fixed abrasive grain type wire saw. That is to say, the grooves 2 may be grooves formed when the crystal is sliced with the fixed abrasive grain type wire saw to produce the thin plate member. In the cutting with the wire saw, a workpiece is cut while the workpiece is pressed against a plurality of ultrathin wire rows parallel to each other at a fixed pitch and a wire is fed with abrasive grains, such as diamond, secured with electrodeposition or an adhesive in a wire direction. In this case, grinding marks are generated in the wire feeding direction, and the grooves 2 similar to those by the surface grinding can be formed. When cutting is performed with the wire saw, the crystal cutting step (Step S2) and the surface processing step (step S3) can be shared, and thus the thin plate member can be efficiently produced. The grooves 2 may be formed by applying a certain amount of pressure with sandpaper or the like. The surface processing step may be electric discharge processing to achieve a certain surface roughness Ra, and the above certain surface roughness may be achieved by, for example, adjusting processing conditions with a wire discharge processing apparatus. In the surface processing step of the magnetostrictive member, grinding having a high processing speed is more suitable from the viewpoint of processing speed. For example, the grinding is suitably wire-saw grinding or surface grinding.

Following the surface processing step (Step S3), the cutting step (Step S4) is performed. The cutting step is a step for cutting the thin plate member formed with the grooves 2 in the surface processing step to obtain the magnetostrictive member 1 of the present embodiment.

In the cutting step, when the thin plate member formed with the grooves 2 is cut to be made into the magnetostrictive member 1, the thin plate member is cut so as to form the grooves 2 extending in the long-side direction of the magnetostrictive member 1. In the cutting step, the thin plate member is cut into a predetermined size. In the cutting step, the thin plate member is cut as the magnetostrictive member 1 such that the magnetostrictive member 1 becomes a rectangular plate-like body in a plan view. In the cutting step, the thin plate member is cut using a cutting apparatus. The cutting apparatus used in the cutting step is not limited to a particular cutting apparatus. For example, an outer peripheral blade cutting apparatus, a wire electric discharge machine, a wire saw, or the like can be used. The direction in which the magnetostrictive member is extracted from the thin plate member, which is not limited to a particular direction, may be set to a direction allowing efficient acquisition depending on the size of the magnetostrictive member or the like, for example.

As described above, in the method for manufacturing a magnetostrictive member of the present embodiment, the magnetostrictive member contains an iron-based alloy crystal having magnetostrictive characteristics and is a plate-like body having front and back faces. The method includes processing at least one of the front and back faces such that the thickness and the surface roughness Ra of the magnetostrictive member satisfy Expression (1) below:

$$\text{Expression (1)}$$
$$\log Ra \geq 0.48t - 0.62$$

In Expression (1) above, log indicates a common logarithm, Ra the surface roughness ($\mu$m), and t the thickness of the magnetostrictive member (mm).

In the method for manufacturing a magnetostrictive member of the present embodiment, any configuration other than the above is optional. The method for manufacturing a magnetostrictive member of the present embodiment can easily manufacture a magnetostrictive member having a high magnetostriction constant and a high parallel magnetostriction amount and small variations in the magnetostriction constant and the parallel magnetostriction amount among members. The effect of the modification of the magnetostriction constant and the parallel magnetostriction amount can be expressed stably at a high level by making the surface roughness of the magnetostrictive member in a certain direction in a certain appropriate range with respect to the plate thickness of the magnetostrictive member.

[Examples]

The following describes the present invention more specifically with reference to examples and comparative examples, but the present invention is not limited by the following examples in any manner.

[Example 1]

With raw materials adjusted with a stoichiometric ratio of iron to gallium of 81:19, a cylindrical single crystal of an Fe-Ga alloy grown by the vertical Bridgman (VB) method was prepared. The growth axis direction of the single crystal was <100>. In the {100} plane of the upper face or the lower face of the single crystal perpendicular to the crystal growth axis direction, the orientation was confirmed by X-ray diffraction. In this process, upper face and lower face samples of the crystal were measured with a Shimadzu sequential plasma emission spectrometer (ICPS-8100), and the concentration of the single crystal had a content of gallium of 17.5 to 19.0 at%.

A magnetostrictive member was manufactured from the grown single crystal as follows. First, using a free abrasive grain type wire saw apparatus, the single crystal was cut in a direction parallel to the single crystal growth direction (parallel to the <100> orientation) and so as to be parallel to the third <100> axial direction to produce a thin plate member with a cut plane, that is, a principal plane of {100}. The thickness of the thin plate member was set to be 1.2 mm, which was 0.2 mm thicker than the plate thickness, so that the thickness after the surface grinding would be 1.0 mm. Next, both faces of the thin plate member were mirror-polished, and the thin plate member was cut into a size of 10 mm × 10 mm. Magnetostrictive characteristics described below were measured for the cut-out magnetostrictive members, and five samples were selected so as to include parts larger and smaller in the parallel magnetostriction amount. Then, the obtained magnetostrictive member was subjected to surface grinding with a surface grinder using a flat grinding wheel of #100 to adjust the thickness of the magnetostrictive member to 1 mm and to form a plurality of grooves (grinding marks) on the front and back faces. In this process, the grinding direction of the surface grinding (a direction in which a plurality of grooves extend) was the first <100> axial direction (the single crystal growth direction).

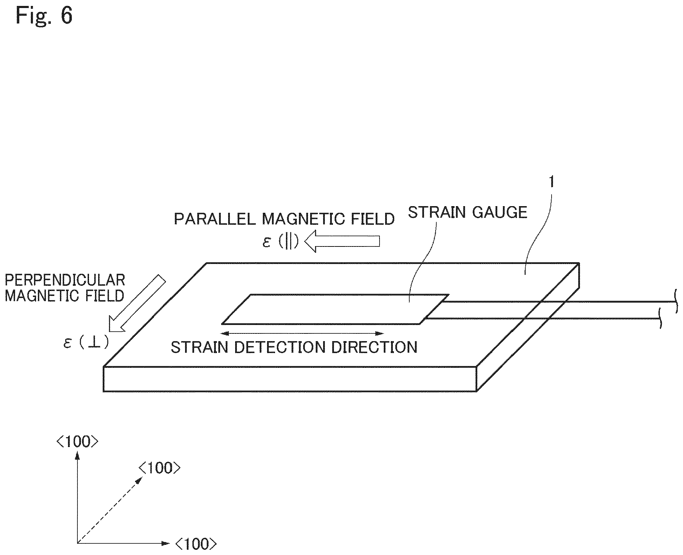

Next, magnetostrictive characteristics were measured for the cut-out magnetostrictive member before and after the surface grinding. Measurement of the magnetostrictive characteristics was performed by the strain gauge method. As illustrated in Fig. 6, a strain gauge (manufactured by Kyowa Electronic Instruments Co., Ltd.) was bonded to the {100} plane, which is the principal plane of the manufactured magnetostrictive member, using an adhesive. The long-side direction of the strain gauge is a magnetostriction detection direction, and thus the strain gauge was bonded such that its long-side direction was parallel to the first <100> axial direction of the magnetostrictive member (the single crystal growth direction) and the measurement direction of the parallel magnetostriction amount was the grinding direction of the surface grinding.

A magnetostriction measuring instrument (manufactured by Kyowa Electronic Instruments Co., Ltd.) included a neodymium-based permanent magnet, a bridge box, a compact recording system, a strain unit, and dynamic data acquisition software.

The magnetostriction amount was determined by correcting an actual strain detection value by a gauge factor.

The gauge factor was determined by Expression (5) below.

$$\text{Expression (5)}$$

$$\varepsilon = 2.00/Ks \times \varepsilon i$$

($\varepsilon$: the gauge factor, $\varepsilon i$: a measured strain value, $Ks$: the gauge factor of the gauge used)

In this process, a direction parallel to the first <100> axial direction (the single crystal growth direction) was defined as the parallel magnetostriction amount. The magnetostriction amount when the magnetic field direction was parallel to the long-side direction of the strain gauge was defined as the parallel magnetostriction amount. The magnetostriction amount when the magnetic field direction was perpendicular to the long-side direction of the strain gauge was defined as the perpendicular magnetostriction amount. The magnetostriction constant was determined by the difference between the parallel magnetostriction amount and the perpendicular magnetostriction amount in accordance with Expression (A). The surface grinding direction is the first <100> axial direction of the magnetostrictive member (the single crystal growth direction), and this direction is the parallel magnetostriction amount.

For the surface of the magnetostrictive member after the surface grinding, the surface roughness Ra was measured at five locations each for the direction perpendicular to the grinding direction of the surface grinding of the magnetostrictive member with a surface roughness meter (VK-X1050 manufactured by Keyence Corporation) at an observation magnification of 20x, and their average was used as the surface roughness Ra. Table 1 lists the manufacturing conditions, the evaluation results, and the like.

[Examples 2 to 12] [Comparative Examples 1 to 5]

For Examples 2 to 12 and Comparative Examples 1 to 5, surface grinding was performed by changing the thickness of the magnetostrictive member from 0.3 mm to 3 mm and the grain size (number) of the grinding wheel with a size of from #40 to #500. The conditions other than the above were the same as in Example 1. Tables 1 to 3 list the thickness of the magnetostrictive member, the grain size (number) of the grinding wheel, the evaluation results, and the like.

[Table 1]

| | No. | Grinding conditions | Plate thickness (mm) | Surface roughness Ra (μm) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Example 1 | 1 | #100 | 1 | 1.233 | | 297 | 279 | 94% | 295 | 289 | 98% |
| | 2 | #100 | 1 | 1.024 | 0.010 | 297 | 221 | 74% | 303 | 299 | 99% |
| | 3 | #100 | 1 | 1.010 | 0.004 | 301 | 143 | 48% | 301 | 297 | 99% |
| | 4 | #100 | 1 | 1.079 | 0.033 | 299 | 13 | 4% | 304 | 300 | 99% |
| | 5 | #100 | 1 | 1.031 | | 290 | 241 | 83% | 304 | 299 | 98% |
| Example 2 | 6 | #60 | 1 | 2.725 | | 296 | 257 | 87% | 298 | 288 | 97% |
| | 7 | #60 | 1 | 2.286 | | 301 | 290 | 96% | 301 | 290 | 96% |
| | 8 | #60 | 1 | 2.049 | 0.312 | 298 | 172 | 58% | 297 | 283 | 95% |
| | 9 | #60 | 1 | 1.694 | 0.229 | 295 | 102 | 35% | 295 | 281 | 95% |
| | 10 | #60 | 1 | 1.838 | | 299 | 282 | 94% | 292 | 279 | 96% |
| Example 3 | 11 | #200 | 0.5 | 0.857 | | 292 | 280 | 96% | 294 | 292 | 99% |
| | 12 | #200 | 0.5 | 0.984 | | 294 | 260 | 88% | 297 | 293 | 99% |
| | 13 | #200 | 0.5 | 0.902 | - 0.045 | 295 | 165 | 56% | 290 | 288 | 99% |
| | 14 | #200 | 0.5 | 0.836 | - 0.078 | 302 | 163 | 54% | 300 | 297 | 99% |
| | 15 | #200 | 0.5 | 0.920 | | 290 | 249 | 86% | 295 | 288 | 98% |

| | No. | Grinding conditions | Plate thickness (mm) | Surface roughness Ra (μm) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Example 4 | 16 | #400 | 0.5 | 0.627 | | 293 | 273 | 93% | 295 | 294 | 100% |
| | 17 | #400 | 0.5 | 0.756 | | 296 | 289 | 98% | 300 | 300 | 100% |
| | 18 | #400 | 0.5 | 0.541 | - 0.267 | 290 | 174 | 60% | 295 | 290 | 98% |
| | 19 | #400 | 0.5 | 0.659 | - 0.181 | 300 | 133 | 44% | 297 | 283 | 95% |
| | 20 | #400 | 0.5 | 0.568 | - 0.246 | 298 | 220 | 74% | 292 | 290 | 99% |
| Example 5 | 21 | #400 | 0.3 | 0.598 | | 282 | 268 | 95% | 281 | 270 | 96% |
| | 22 | #400 | 0.3 | 0.611 | | 290 | 278 | 96% | 285 | 280 | 98% |
| | 23 | #400 | 0.3 | 0.577 | - 0.239 | 281 | 108 | 38% | 282 | 278 | 99% |
| | 24 | #400 | 0.3 | 0.659 | - 0.181 | 285 | 131 | 46% | 287 | 275 | 96% |
| | 25 | #400 | 0.3 | 0.664 | - 0.178 | 282 | 189 | 67% | 288 | 277 | 96% |

EP 4 328 361 A1

[Table 2]

| | No. | Grinding conditions | Plate thickness (mm) | Surface roughness Ra ($\mu$m) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Example 6 | 26 | #500 | 0.3 | 0.537 | | 288 | 270 | 94% | 284 | 282 | 99% |
| | 27 | #500 | 0.3 | 0.577 | | 285 | 275 | 96% | 283 | 283 | 100% |
| | 28 | #500 | 0.3 | 0.524 | -0.281 | 282 | 119 | 42% | 285 | 281 | 99% |
| | 29 | #500 | 0.3 | 0.511 | -0.292 | 280 | 76 | 27% | 280 | 278 | 99% |
| | 30 | #500 | 0.3 | 0.552 | -0.258 | 281 | 164 | 58% | 280 | 279 | 100% |
| Example 7 | 31 | #40 | 1.5 | 5.633 | | 303 | 301 | 99% | 300 | 294 | 98% |
| | 32 | #40 | 1.5 | 4.892 | | 304 | 302 | 99% | 299 | 300 | 100% |
| | 33 | #40 | 1.5 | 4.567 | | 308 | 270 | 88% | 303 | 290 | 96% |
| | 34 | #40 | 1.5 | 7.094 | 0.851 | 305 | 129 | 42% | 310 | 299 | 96% |
| | 35 | #40 | 1.5 | 5.882 | | 300 | 277 | 92% | 304 | 288 | 95% |
| Example 8 | 36 | #80 | 1.5 | 1.649 | | 299 | 290 | 97% | 303 | 300 | 99% |
| | 37 | #80 | 1.5 | 1.561 | | 302 | 300 | 99% | 300 | 299 | 100% |
| | 38 | #80 | 1.5 | 1.807 | | 305 | 278 | 91% | 310 | 298 | 96% |
| | 39 | #80 | 1.5 | 1.711 | 0.233 | 315 | 155 | 49% | 328 | 305 | 93% |
| | 40 | #80 | 1.5 | 1.538 | | 302 | 269 | 89% | 300 | 298 | 99% |
| Example 9 | 41 | #40 | 2 | 6.191 | | 298 | 275 | 92% | 288 | 285 | 99% |
| | 42 | #40 | 2 | 5.846 | | 302 | 296 | 98% | 287 | 283 | 99% |
| | 43 | #40 | 2 | 6.423 | 0.808 | 305 | 236 | 77% | 292 | 285 | 98% |
| | 44 | #40 | 2 | 7.818 | 0.893 | 304 | 168 | 55% | 302 | 301 | 100% |
| | 45 | #40 | 2 | 6.224 | | 308 | 260 | 84% | 304 | 302 | 99% |

| | No. | Grinding conditions | Plate thickness (mm) | Surface roughness Ra (μm) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Example 10 | 46 | #50 | 2 | 2.884 | | 301 | 280 | 93% | 299 | 290 | 97% |
| | 47 | #50 | 2 | 2.748 | | 303 | 300 | 99% | 305 | 299 | 98% |
| | 48 | #50 | 2 | 3.529 | 0.548 | 307 | 205 | 67% | 303 | 290 | 96% |
| | 49 | #50 | 2 | 2.582 | 0.412 | 312 | 74 | 24% | 315 | 298 | 95% |
| | 50 | #50 | 2 | 2.856 | | 300 | 244 | 81% | 305 | 303 | 99% |
| Example 11 | 51 | #40 | 2.5 | 6.166 | | 295 | 272 | 92% | 290 | 288 | 99% |
| | 52 | #40 | 2.5 | 5.813 | | 300 | 291 | 97% | 293 | 290 | 99% |
| | 53 | #40 | 2.5 | 5.094 | 0.707 | 307 | 115 | 37% | 294 | 282 | 96% |
| | 54 | #40 | 2.5 | 4.226 | 0.626 | 308 | 98 | 32% | 303 | 282 | 93% |
| | 55 | #40 | 2.5 | 4.747 | | 303 | 245 | 81% | 299 | 284 | 95% |
| Example 12 | 56 | #400 | 0.75 | 0.584 | | 295 | 257 | 87% | 294 | 285 | 97% |
| | 57 | #400 | 0.75 | 0.550 | | 290 | 280 | 97% | 288 | 285 | 99% |
| | 58 | #400 | 0.75 | 0.604 | | 285 | 231 | 81% | 289 | 285 | 99% |
| | 59 | #400 | 0.75 | 0.663 | -0.178 | 281 | 118 | 42% | 290 | 281 | 97% |
| | 60 | #400 | 0.75 | 0.621 | | 299 | 250 | 84% | 294 | 292 | 99% |

[Table 3]

| | No. | Grinding conditions | Plate thickness (mm) | Surface roughness Ra (μm) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Comparative Example 1 | 61 | #400 | 1 | 0.569 | | 295 | 281 | 95% | 297 | 296 | 100% |
| | 62 | #400 | 1 | 0.622 | | 296 | 278 | 94% | 300 | 294 | 98% |
| | 63 | #400 | 1 | 0.643 | -0.192 | 299 | 124 | 41% | 298 | 175 | 59% |
| | 64 | #400 | 1 | 0.648 | -0.188 | 298 | 191 | 64% | 303 | 223 | 74% |
| | 65 | #400 | 1 | 0.661 | -0.180 | 304 | 98 | 32% | 292 | 196 | 67% |
| Comparative Example 2 | 66 | #200 | 1.5 | 0.826 | | 300 | 275 | 92% | 302 | 293 | 97% |
| | 67 | #200 | 1.5 | 0.978 | | 303 | 288 | 95% | 299 | 300 | 100% |
| | 68 | #200 | 1.5 | 0.917 | -0.038 | 305 | 138 | 45% | 304 | 255 | 84% |
| | 69 | #200 | 1.5 | 0.924 | -0.034 | 317 | 81 | 26% | 306 | 233 | 76% |
| | 70 | #200 | 1.5 | 0.940 | | 309 | 268 | 87% | 295 | 290 | 98% |
| Comparative Example 3 | 71 | #80 | 2 | 1.632 | | 290 | 268 | 92% | 297 | 280 | 94% |
| | 72 | #80 | 2 | 1.422 | | 299 | 285 | 95% | 298 | 296 | 99% |
| | 73 | #80 | 2 | 1.519 | 0.182 | 295 | 222 | 75% | 290 | 256 | 88% |
| | 74 | #80 | 2 | 1.393 | 0.144 | 302 | 69 | 23% | 289 | 77 | 27% |
| | 75 | #80 | 2 | 1.475 | 0.169 | 292 | 134 | 46% | 283 | 143 | 51% |
| Comparative Example 4 | 76 | #100 | 2 | 1.045 | | 295 | 290 | 98% | 302 | 294 | 97% |
| | 77 | #100 | 2 | 1.009 | | 302 | 292 | 97% | 304 | 297 | 98% |
| | 78 | #100 | 2 | 1.068 | | 298 | 241 | 81% | 300 | 264 | 88% |
| | 79 | #100 | 2 | 1.110 | 0.045 | 315 | 114 | 36% | 301 | 154 | 51% |
| | 80 | #100 | 2 | 1.062 | 0.026 | 304 | 215 | 71% | 302 | 249 | 82% |

| | No. | Grinding conditions | Plate thickness (mm) | Surface roughness Ra ($\mu$m) | log Ra | Magnetostriction constant before processing (ppm) | Parallel magnetostriction amount before processing (ppm) | Ratio before processing | Magnetostriction constant after processing (ppm) | Parallel magnetostriction amount after processing (ppm) | Ratio after processing |
|---|---|---|---|---|---|---|---|---|---|---|---|
| Comparative Example 5 | 81 | #40 | 3 | 5.827 | | 288 | 264 | 92% | 290 | 270 | 93% |
| | 82 | #40 | 3 | 6.115 | | 290 | 275 | 95% | 295 | 277 | 94% |
| | 83 | #40 | 3 | 5.006 | 0.699 | 295 | 134 | 45% | 298 | 161 | 54% |
| | 84 | #40 | 3 | 4.716 | 0.674 | 298 | 88 | 30% | 303 | 144 | 48% |
| | 85 | #40 | 3 | 6.033 | 0.781 | 294 | 201 | 68% | 290 | 233 | 80% |

[Conclusion]

From the results of the examples and the comparative examples as listed in Tables 1 to 3 and Figs. 7 and 8, it is confirmed that setting the thickness and the surface roughness Ra of the magnetostrictive member within the above ranges enables the effect of the modification of the magnetostriction constant and the parallel magnetostriction amount to be expressed stably at a high level.

The technical scope of the present invention is not limited to the aspects described in the embodiments and the like described above. One or more of the requirements described in the embodiments and the like described above may be omitted. The requirements described in the embodiments and the like described above can be combined as appropriate. To the extent permitted by law, the disclosure of Japanese Patent Application No. 2021-073603, which is a Japanese patent application, and all the references cited in the embodiments and the like described above is incorporated herein by reference.

Description of Reference Signs

1      Magnetostrictive member
2      Groove
3      Front face
4      Back face
S1     Crystal preparation step
S2     Crystal cutting step
S3     Surface processing step
S4     Cutting step

**Claims**

1.  A magnetostrictive member comprising an iron-based alloy crystal having magnetostrictive characteristics,

    being a plate-like body having front and back faces,
    in one of the front and back faces, a thickness and a surface roughness Ra of the magnetostrictive member satisfying Expression (1) below:

$$\text{Expression (1)}$$
$$\log Ra \geq 0.48t - 0.62$$

    in Expression (1) above, log indicating a common logarithm, Ra indicating surface roughness ($\mu$m), and t indicating thickness of the magnetostrictive member (mm).

2.  The magnetostrictive member according to claim 1, wherein

    the surface roughness Ra is 1.0 um or less when the thickness of the magnetostrictive member is 0.3 mm or more and 0.75 mm or less, and
    the surface roughness Ra is 8.6 um or less when the thickness of the magnetostrictive member is more than 0.75 mm.

3.  The magnetostrictive member according to claim 2, wherein

    the surface roughness Ra is 0.5 um or more when the thickness of the magnetostrictive member is more than 0.3 mm and 0.75 or less,
    the surface roughness Ra is 1.0 um or more when the thickness of the magnetostrictive member is more than 0.75 mm and 1.0 mm or less,
    the surface roughness Ra is 1.3 um or more when the thickness of the magnetostrictive member is more than 1.0 mm and 1.5 mm or less,
    the surface roughness Ra is 2.5 um or more when the thickness of the magnetostrictive member is more than 1.5 mm and 2.0 mm or less, and
the surface roughness Ra is 4.0 um or more when the thickness of the magnetostrictive member is more than 2.0 mm and 2.5 mm or less.

4. The magnetostrictive member according to any one of claims 1 to 3, wherein

the thickness and the surface roughness Ra of the magnetostrictive member satisfy Expression (2) below when the thickness of the magnetostrictive member is 0.5 mm or more and 0.75 mm or less,
the thickness and the surface roughness Ra of the magnetostrictive member satisfy Expression (3) below when the thickness of the magnetostrictive member is more than 0.75 mm and 1.0 mm or less, and
the thickness and the surface roughness Ra of the magnetostrictive member satisfy Expression (4) below when the thickness of the magnetostrictive member is more than 1.0 mm and 0.1.5 mm or less:

$$\text{Expression (2)}$$
$$\log Ra \leq 0.92t - 0.45$$

$$\text{Expression (3)}$$
$$\log Ra \leq 1.48t - 1.01$$

$$\text{Expression (4)}$$
$$\log Ra \leq 0.40t - 0.20$$

in Expressions (2) to (4) above, log indicating a common logarithm, Ra the surface roughness ($\mu$m), and t the thickness of the magnetostrictive member (mm).

5. The magnetostrictive member according to any one of claims 1 to 4, wherein a parallel magnetostriction amount/magnetostriction constant ratio of the magnetostrictive member is 80% or more.

6. The magnetostrictive member according to any one of claims 1 to 5,

having a magnetostriction constant of 250 ppm or more, and
having a parallel magnetostriction amount of 250 ppm or more.

7. The magnetostrictive member according to any one of claims 1 to 6, wherein the iron-based alloy is an Fe-Ga alloy single crystal.

8. The magnetostrictive member according to any one of claims 1 to 7, wherein the thickness of the magnetostrictive member is 0.3 mm or more and 2.5 mm or less.

9. A method for manufacturing a magnetostrictive member comprising an iron-based alloy crystal having magnetostrictive characteristics and being a plate-like body having front and back faces, the method comprising processing at least one of the front and back faces such that a thickness and a surface roughness Ra of the magnetostrictive member satisfy Expression (1) below:

$$\text{Expression (1)}$$
$$\log Ra \geq 0.48t - 0.62$$

in Expression (1) above, log indicating a common logarithm, Ra indicating surface roughness ($\mu$m), and t indicating thickness of the magnetostrictive member (mm).

10. The method for manufacturing a magnetostrictive member according to claim 9, wherein the processing is grinding.

11. The method for manufacturing a magnetostrictive member according to claim 10, wherein the grinding is surface grinding.

12. The method for manufacturing a magnetostrictive member according to claim 11, wherein the surface grinding is performed using a grinding wheel of #40 or more and #500 or less and includes selecting a grinding wheel of a number causing the thickness and the surface roughness Ra of the magnetostrictive member to satisfy Expression (1) above.

13. The method for manufacturing a magnetostrictive member according to any one of claims 9 to 12, wherein the processing includes processing to achieve a magnetostriction constant of 250 ppm or more and a parallel magnetostriction amount of 250 ppm or more.

Fig. 1

GRINDING DIRECTION,
LONG-SIDE DIRECTION

<u>1</u>

GROOVE 2    FRONT FACE 3 (100 PLANE)

SIDE FACE 5
(100 PLANE)

THICKNESS
DIRECTION

BACK FACE 4
(100 PLANE)

SIDE FACE 6
(100 PLANE)

Fig. 2

```
┌─────────────────────────────────┐
│   CRYSTAL PREPARATION STEP       │─S1
└─────────────────────────────────┘
                 │
                 ▼
┌─────────────────────────────────┐
│     CRYSTAL CUTTING STEP         │─S2
└─────────────────────────────────┘
                 │
                 ▼
┌─────────────────────────────────┐
│    SURFACE PROCESSING STEP       │─S3
└─────────────────────────────────┘
                 │
                 ▼
┌─────────────────────────────────┐
│         CUTTING STEP             │─S4
└─────────────────────────────────┘
```

Fig. 3

SINGLE CRYSTAL

FIRST {100} PLANE

THIRD <100> AXIS

SECOND <100> AXIS

FIRST <100> AXIS

THIN PLATE MEMBER

FIRST{100} PLANE

THIRD {100} PLANE

SECOND {100} PLANE

MAGNETOSTRICTIVE
MEMBER

FIRST{100} PLANE

THIRD {100} PLANE

SECOND {100} PLANE

## Fig. 4

SINGLE CRYSTAL

FIRST {100} PLANE

THIRD <100> AXIS

SECOND <100> AXIS

FIRST <100> AXIS

THIN PLATE MEMBER

FIRST {100} PLANE

THIRD {100} PLANE

SECOND {100} PLANE

MAGNETOSTRICTIVE MEMBER

FIRST {100} PLANE

THIRD {100} PLANE

SECOND {100} PLANE

## Fig. 5

SINGLE CRYSTAL

FIRST {100} PLANE

THIRD <100> AXIS

SECOND <100> AXIS

FIRST <100> AXIS

THIN PLATE MEMBER

FIRST{100} PLANE

MAGNETOSTRICTIVE
MEMBER

FIRST{100} PLANE

THIRD {100} PLANE

SECOND {100} PLANE

FIRST{100} PLANE

THIRD {100} PLANE

SECOND {100} PLANE

Fig. 6

PARALLEL MAGNETIC FIELD  STRAIN GAUGE

ε (∥)

PERPENDICULAR
MAGNETIC FIELD

ε (⊥)

STRAIN DETECTION DIRECTION

1

⟨100⟩

⟨100⟩

⟨100⟩

Fig. 7

EVALUATION RESULTS OF MAGNETOSTRICTION AMOUNT

log Ra = 0.48t -0.62

PLATE THICKNESS   t(mm)

Fig. 8

EVALUATION RESULTS OF MAGNETOSTRICTION AMOUNT

## INTERNATIONAL SEARCH REPORT

International application No.

**PCT/JP2022/018229**

**A. CLASSIFICATION OF SUBJECT MATTER**

*C30B 29/62*(2006.01)i; *B24B 7/22*(2006.01)i; *C22C 38/00*(2006.01)i; *C30B 29/52*(2006.01)i; *H01L 41/20*(2006.01)i; *H01L 41/47*(2013.01)i
FI: C30B29/62 U; C30B29/52; H01L41/20; H01L41/47; B24B7/22 Z; C22C38/00 303Z

According to International Patent Classification (IPC) or to both national classification and IPC

**B. FIELDS SEARCHED**

Minimum documentation searched (classification system followed by classification symbols)

C30B29/62; B24B7/22; C22C38/00; C30B29/52; H01L41/20; H01L41/47

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-107715 A (NIPPON STEEL CHEMICAL & MATERIAL CO., LTD.) 09 July 2020 (2020-07-09)<br>entire text | 1-13 |
| A | JP 10-239177 A (MATSUSHITA ELECTRIC INDUSTRIAL CO., LTD.) 11 September 1998 (1998-09-11)<br>entire text | 1-13 |
| A | JP 2020-050920 A (PANASONIC INTELLECTUAL PROPERTY MANAGEMENT CO., LTD.) 02 April 2020 (2020-04-02)<br>entire text | 1-13 |
| A | JP 2016-138028 A (NIPPON KOSHUHA STEEL CO., LTD.) 04 August 2016 (2016-08-04)<br>entire text | 1-13 |
| A | JP 2020-200209 A (SUMITOMO METAL MINING CO., LTD.) 17 December 2020 (2020-12-17)<br>entire text | 1-13 |

☑ Further documents are listed in the continuation of Box C.     ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **14 June 2022** | **21 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**EP 4 328 361 A1**

| | INTERNATIONAL SEARCH REPORT | International application No. |
|---|---|---|
| | | **PCT/JP2022/018229** |

**C.    DOCUMENTS CONSIDERED TO BE RELEVANT**

| Category* | Citation of document, with indication, where appropriate, of the relevant passages | Relevant to claim No. |
|---|---|---|
| P, X | WO 2021/100467 A1 (SUMITOMO METAL MINING CO., LTD.) 27 May 2021 (2021-05-27)<br>claims, paragraphs [0065]-[0087], fig. 1 | 1-13 |
| E, X | JP 2022-074526 A (SUMITOMO METAL MINING CO., LTD.) 18 May 2022 (2022-05-18)<br>claims, paragraphs [0071]-[0084], fig. 1 | 1, 2, 4-13 |
| E, A | | 3 |

Form PCT/ISA/210 (second sheet) (January 2015)

32

**INTERNATIONAL SEARCH REPORT**
**Information on patent family members**

International application No.

**PCT/JP2022/018229**

| Patent document cited in search report | | | Publication date (day/month/year) | Patent family member(s) | | | Publication date (day/month/year) |
|---|---|---|---|---|---|---|---|
| JP | 2020-107715 | A | 09 July 2020 | (Family: none) | | | |
| JP | 10-239177 | A | 11 September 1998 | (Family: none) | | | |
| JP | 2020-050920 | A | 02 April 2020 | US entire text CN | 2020/0105997 110957416 | A1 A | |
| JP | 2016-138028 | A | 04 August 2016 | US entire text US WO EP CN | 2017/0317266 2018/0233654 2016/121132 3252192 107109683 | A1 A1 A1 A1 A | |
| JP | 2020-200209 | A | 17 December 2020 | (Family: none) | | | |
| WO | 2021/100467 | A1 | 27 May 2021 | (Family: none) | | | |
| JP | 2022-074526 | A | 18 May 2022 | (Family: none) | | | |

Form PCT/ISA/210 (patent family annex) (January 2015)

33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016028831 A
- JP 2016138028 A
- JP H04108699 A
- JP 2015517024 W
- WO 2011158473 A
- JP 2021073603 A

**Non-patent literature cited in the description**

- **ETREMA.** *State of the Art of Galfenol Processing*
- **A. E. CLARK et al.** *Appl. Phys.,* 2003, vol. 93, 8621
- **JUNG JIN PARK ; SUOK-MIN NA ; GANESH RAGHUNATH ; ALISON B. FLATAU.** *AIP Advances,* 2016, vol. 6, 056221
- **TOSHIYUKI UENO.** *Journal of Japan Society for Precision Engineering,* 2013, vol. 79 (4), 305-308